# EUROPÄISCHE PATENTSCHRIFT

(11) **EP 1 097 481 B1**
(45) Veröffentlichungstag und Bekanntmachung des Hinweises auf die Patenterteilung: **31.03.2004**
(21) Anmeldenummer: 99944236.1
(22) Anmeldetag: 01.07.1999
(51) Int. Cl.: H01L 29/36, H01L 29/10, H01L 29/739

(54) **LEISTUNGSHALBLEITERBAUELEMENT FÜR HOHE SPERRSPANNUNGEN**
POWER SEMICONDUCTOR COMPONENT FOR HIGH BLOCKING VOLTAGES
COMPOSANT A SEMI-CONDUCTEUR DE PUISSANCE POUR TENSIONS DE BLOCAGE ELEVEES

(30) Priorität: 17.07.1998 DE 19832310; 23.10.1998 DE 19848985
(43) Veröffentlichungstag der Anmeldung: 09.05.2001
(73) Patentinhaber: Infineon Technologies AG, 81669 München (DE)
(72) Erfinder: PORST, Alfred, D-81149 München (DE); STRACK, Helmut, D-80804 München (DE); MAUDER, Anton, D-83059 Kolbermoor (DE); SCHULZE, Hans-Joachim, D-85521 Ottobrunn (DE); BRUNNER, Heinrich, D-84405 Dorfen (DE); BAUER, Josef, D-85229 Markt Indersdorf (DE); BARTHELMESS, Reiner, D-97483 Eltmann (DE)
(74) Vertreter: Epping, Hermann, Fischer
(86) Internationale Anmeldenummer: PCT/DE1999/001956
(87) Internationale Veröffentlichungsnummer: WO 2000/004596

(56) Entgegenhaltungen:
- EP-A- 0 214 485
- EP-A- 0 760 528
- DE-A- 3 917 769
- US-A- 5 668 385

## Beschreibung

Die Erfindung betrifft Leistungshalbleiterbauelemente, insbesondere für hohe Sperrspannungen, die aus einer n-dotiertem Siliziumschicht, in welches zwischen einer ersten Hauptfläche und einer zweiten Hauptfläche mehrere n- oder p-dotierte Schichten eingebracht sind, einer Kathode, welche der ersten Hauptfläche zugeordnet ist und durch eine erste Metallisierung gebildet wird, sowie eine Anode, welche durch eine die zweite Hauptfläche bedeckende, zweite Metallisierung gebildet wird, bestehen.

Solche Leistungshalbleiterbauelemente können zum einen so aufgebaut sein, daß die Schichten von der zweiten Hauptfläche her gesehen, einen p-dotierten Anoden-Zone, an diese angrenzend eine n-dotierte Stoppschicht, die eine höhere Dotierstoffkonzentration aufweist als die Siliziumschicht, und daran angrenzend die n-dotierte Siliziumschicht umfassen.

Solche Bauelemente sind als bipolare Transistoren, Thyristoren bzw. als durch Feldeffekt steuerbare bipolare Leistungshalbleiterbauelemente (IGBT) weithin bekannt und beispielsweise in der US 5,668,385 dargestellt.

In einer anderen Ausführung können die obengenannten Leistungshalbleiterbauelemente Schichten aufweisen, die von der zweiten Hauptfläche her gesehen, einen p-dotierten Anoden-Zone und daran angrenzend die n-dotierte, Silizium-Schicht daran eine angrenzende Stoppschicht, die eine höhere Dotierstoffkonzentration als die n-dotierte Siliziumschicht aufweist und daran angrenzend eine n-dotierte Kathodenzone, umfassen.

Solche Leistungshalbleiterbauelemente sind gemeinhin als Dioden bekannt, und können entweder als diskrete eigentliche Bauelemente vorliegen oder als parasitäre Dioden in anderen Leistungshalbleiterbauelementen enthalten sein, wie z. B. in Leistungs-MISFETs. Bei einem Leistungs-MISFET ist bekanntlich antiparallel zum eigentlichen MISFET von Source nach Drain eine parasitäre p⁺-n⁻-n⁺-Diode geschaltet.

Solche Leistungshalbleiterbauelement sind ebenfalls beispielsweise in der US 5,668,385 dargestellt.

Solche Stoppschichten wurden bisher vorwiegend durch tiefe Diffusionen hergestellt, die jedoch sehr lange Diffusionszeiten beanspruchen. Des Weiteren ist der Dotierungsverlauf auch nicht frei wählbar, was aus der EP 0 214 485 A1 bekannt ist.

Ferner ist es auch bekannt, solche Stoppschichten epitaktisch auf ein stark n-dotiertes Substrat abzuscheiden. Die Epitaxie ist jedoch ein sehr teures Verfahren, insbesondere im Hinblick auf die bei Leistungshalbleiterbauelementen notwendigen Schichtdicken, und weist darüber hinaus die Problematik auf, daß des öfteren nicht erwünschte, zu große Defektdichten entstehen.

Der Erfindung liegt daher die Aufgabe zugrunde, neue Leistungshalbleiterbauelemente zur Verfügung zu stellen, die eine Stoppschicht aufweisen, bei denen die Stoppschicht nicht epitaktisch abgeschieden werden muß oder deren Herstellung lang dauernde Tiefdiffusionen erforderlich machen.

Erfindungsgemäß wird die Aufgabe dadurch gelöst, daß die Stoppschicht mit zumindest einem Dotierstoff dotiert ist, der zumindest ein Donatorniveau aufweist, das zwischen der Valenzbandkante und der Leitungsbandkante von Silizium liegt und einen Abstand von der Leitungsbandkante des Siliziums von mehr als 200 meV aufweist. Solche Dotierstoffe sind insbesondere Schwefel oder Selen.

Schwefel weist zwei Donatorniveaus, nämlich bei 260 meV bzw. 480 meV, und Selen zwei Donatorniveaus, nämlich bei 310 meV und 590 meV, unterhalb der Leitungsbandkante auf.

Die Verwendung von Dotierstoffen mit diesen Eigenschafter ist aus DE-A-3 917 769 zur Verringerung des Temperatur gangs des Zündstroms in Thyristoren mit Emitter-Nebenschlüssen bekannt.

Im Vergleich zu den technisch weit verbreiteten Donatoren, Phosphor, Arsen und Antimon, deren Energieniveaus weniger als 50 meV Abstand zur Leitungsbandkante aufweisen, bedeutet dies, daß im üblichen Betriebstemperaturbereich von aus Silizium bestehenden Leistungshalbleiterbauelementen, d. h. in einem Temperaturintervall von ca. -55°C bis +175°C, nur ein sehr kleiner Anteil der Donatoratome im thermischen Gleichgewicht in ionisiertem Zustand vorliegt.

Demnach ist die Stoppschicht bei den Leistungshalbleiterbauelementen gemäß der vorliegenden Erfindung nur im Sperrbetrieb des Leistungshalbleiterbauelements "aktiv", nicht aber jedoch im Durchlaßbetrieb. Mit anderen Worten, die Anzahl der durch die Störstellen in der Stoppschicht erzeugten, als Dotierstoff wirksamen Atome ändert sich in Abhängigkeit von der Betriebsart des Leistungshalbleiterbauelements. Dies wird dadurch erreicht, daß durch die Dotieratome Donatorniveaus bereitgestellt werden, die innerhalb der Bandlücke des Siliziums weit entfernt von der Leitungsbandkante und von der Valenzbandkante liegen.

Ein weiterer Vorteil der Verwendung von Schwefel oder Selen als Dotierstoff liegt darin, daß die Diffusionskonstanten beider Elemente in Silizium sehr hoch ist im Vergleich zu den Dotierstoffen gemäß dem Stand der Technik. Die Diffusionskoeffizienten sind im Vergleich in der Figur 5 wiedergegeben.

Vorzugsweise weist die Stoppschicht eine Dotierstoffkonzentration N_{D} zwischen 5x10¹⁴ cm⁻³ und 5x10¹⁵ cm⁻³ auf, wobei die Stoppschicht bei Leistungsdioden eine Tiefe zwischen 15 µm und 35 µm aufweist und bei IGBTs und anderen steuerbaren Leistungshalbleiterbauelementen eine Tiefe zwischen 10 µm und 25 µm aufweist.

Ferner weisen die erfindungsgemäßen Leistungshalbleiterbauelemente eine Anodenstruktur auf, welche die erfindungsgemäße Stoppschicht zur anodenseitigen Begrenzung des elektrischen Feldes in Kombination mit Mitteln zur maximalen, anodenseitigen Extraktion von Ladungsträgern während des Abschaltvorgangs optimiert.

Dies wird durch einen Anoden-Emitter erreicht, der als transparenter Emitter ausgeführt ist und dessen Tiefe und Ladungsträgerkonzentration vorzugsweise so gewählt sind, daß mindestens 50% eines durch den Emitter fließenden Gesamtstromes von Elektronen getragen werden. Unter einem transparenten Emitter wird im folgenden eine anodenseitige Emitterschicht verstanden, welche so gestaltet ist, daß ein signifikanter Anteil des Gesamtstromes die Anodenmetallisierung des Leistungshalbleiterbauelements als Elektronenstrom verläßt. Diesen in Prozent des Gesamtstroms angegebenen Elektronenstrom bezeichnet man als Emittertransparenz. Die Emittertransparenz wird durch Tiefe und Randkonzentration des Anodenemitters eingestellt. Dadurch werden hohe Tailströme bei den erfindungsgemäßen steuerbaren Halbleiterbauelementen vermieden. Durch die Variation der Tiefe der Stoppschicht, ihrer maximalen Dotierstoffkonzentration und ihres Dotierungsgradienten einerseits, sowie durch Einstellung von Dotierstoffkonzentration und Tiefe des transparenten Emitters andererseits kann ein breites Spektrum von Abschaltstromverläufen über die Zeit eingestellt werden. Das heißt von einem abrupten Stromabriß mit minimalen Abschaltverlusten (hard recovery) bis zu einem weichen Abklingen des Stroms mit nur geringfügig höheren Abschaltverlusten (soft recovery) sind alle gewünschten und denkbaren Abschaltstromverläufe erzielbar.

Die Kombination des transparenten Anodenemitters mit der Stoppschicht hat also u.a. den Effekt, daß die Raumladungszone während des Abschaltvorgangs in die Stoppschicht eindringt und die Ladung durch den transparenten Emitter aus dem Leistungshalbleiterbauelement schiebt. Als Folge davon fällt der Strom in sehr kurzer Zeit auf 0 ab, ohne die bei konventionellen Strukturen typischen, langsam abfallenden Tailströme. Dadurch werden die Abschaltverluste drastisch minimiert.

Bei einer Leistungsdiode ist die Stoppschicht nicht auf der Anodenseite, sondern auf der Kathodenseite angeordnet. Bei der Leistungsdiode wechselt der Strom bei Übergang vom Durchlaßbetrieb in den Sperrbetrieb bekanntlich die Richtung. Dieses Phänomen ist in der Literatur als "Reverse Recovery" bekannt. Wie oben ausgeführt, verhindert die kathodenseitige Stoppschicht bei der Leistungsdiode ein abruptes Abreißen des Stroms am Ende der Reverse-Recovery-Phase. Der transparente Anodenemitter kann auch bei einer Leistungs-Diode vorteilhaft mit der kathodenseitigen Stoppschicht kombiniert werden, da die gleichzeitige Verwendung dieser beiden Mittel die Minimierung der Leistungsdiodendicke, d. h. also die Minimierung der schwach n-dotierten Schicht zwischen Anode und Kathode, bei gleichzeitig schwacher Injektion von der Anodenseite her erfolgen kann. Dies ist der effektivste Weg zur Reduktion der Rückstromspitze. Die kathodenseitige Stoppschicht stellt also sicher, daß das Abklingen des Leistungsdiodenrückstroms weich erfolgt (Soft-Recovery).

Wird die Emittertransparenz sehr hoch eingestellt, so wird der Durchlaßwiderstand für praktische Anwendungen in der Regel zu hoch. Diesem Nachteil kann aber auf einfache Weise abgeholfen werden, indem der transparente Anoden-Emitter mit stark p-dotierten Inseln durchsetzt wird. Diese spezielle Ausführungsform entspricht einer weiteren, bevorzugten Ausführungsform und kann sowohl bei Leistungsdioden als auch bei steuerbaren Leistungshalbleiterbauelementen zur Anwendung kommen.

Bei IGBTs weisen die Leistungshalbleiterbauelemente von der kathodenseitigen Hauptfläche eine Vielzahl von IGBT-Zellen bestehend aus p-dotierten Basiszonen und darin eingebetteten n-dotierten Sourcezonen auf, wobei die Kathode mit den Basiszonen und Sourcezonen elektrisch leitend verbunden ist. Über der kathodenseitigen Hauptfläche sind dann zwischen jeweils zwei IGBT-Zellen eine über einen Isolator isolierte Gateelektrode vorgesehen.

Bei Thyristoren ist von der kathodenseitigen Hauptfläche eine p-dotierte Basiszone und darin eine Mehrzahl von n-dotierten Kathodenzonen eingebracht, wobei die Kathodenzonen mit der Kathode elektrisch leitend verbunden sind.

Bei den IGBTs weist der transparente Anoden-Emitter vorzugsweise eine Tiefe kleiner 1 µm auf, wohingegen bei Leistungsdioden der transparente Anoden-Emitter typischerweise eine Tiefe von zwischen 0,5 µm und 5 µm aufweist.

Es wird nocheinmal herausgestellt, daß die erfindungsgemäßen Stoppschichten auch bei parasitären Diodenstrukturen gezielt verwendet werden können, d.h. die Erfindung sich auch u.a. auf unipolare Leistungshalbleiterbauelemente erstreckt. Es ist allgemein bekannt, daß Leistungs-MOSFETs eine antiparallel zum eigentlichen Leistungs-MOSFET von Source nach Drain eine parasitäre Diodenstruktur aufweisen. Diese parasitäre Leistungsdiode hat ihrerseits eine Diffusionskapazität bzw. eine Sperrschichtkapazität, die bei der Entwicklung und Dimensionierung von Leistungs-MOSFETs berücksichtigt werden muß. Die Erfindung eröffnet demnach auch hier neue Wege, bei der Dimensionierung und Entwicklung von unipolaren Leistungshalbleiterbauelementen.
- Figur 1a: eine erfindungsgemäße Stoppschicht für ein steuerbares Leistungshalbleiterbauelement mit transparentem Emitter;
- Figur 1b: eine erfindungsgemäße Stoppschicht für ein steuerbares Leistungshalbleiterbauelement mit einem transparenten Emitter und stark p-dotierten Emitterinseln;
- Figur 2a: eine Kathodenstruktur eines IGBTs;
- Figur 2b: eine Kathodenstruktur eines MCTs;
- Figur 2c: eine Kathodenstruktur eines GTOs;
- Figur 3: eine erfindungsgemäße Struktur einer Leistungsdiode und
- Figur 4: das Dotierungsprofil der Leistungsdiode nach Figur 3.

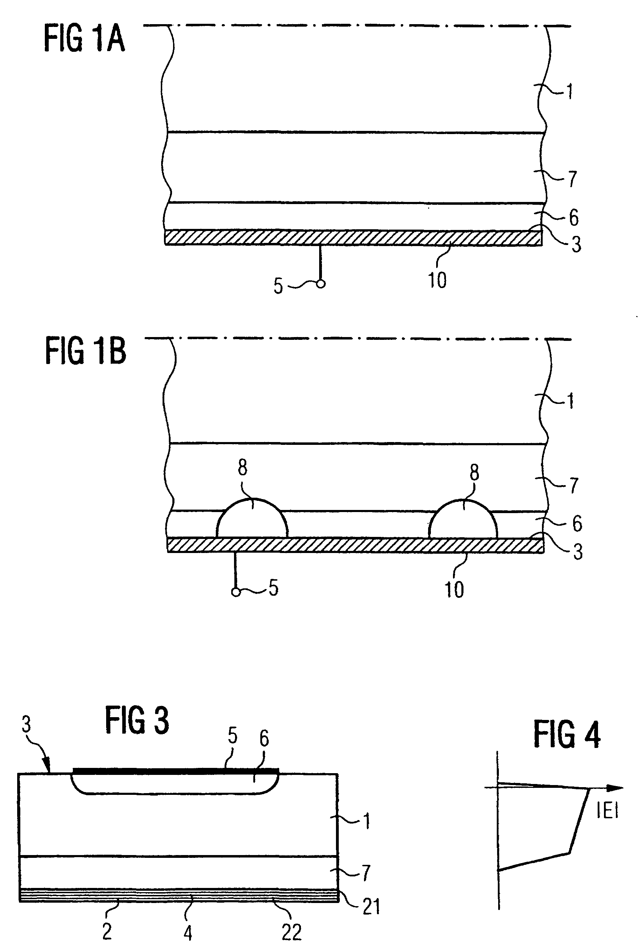

In einer Weiterentwicklung der vorliegenden Erfindung werden in den transparenten Emitter (6) stark p-dotierte Emitterinseln (8) eingebracht. Eine solche Anodenstruktur ist in der Figur 1b dargestellt. Sie kann für IGBT, MCT und GTO eingesetzt werden. Die Tiefe dieser Emitterinseln beträgt beispielsweise 5 µm und die Dotierstoffkonzentration am Rand ungefähr 10¹⁹cm⁻³. Durch die Verwendung solcher stark p-dotierten Emitterinseln (8) sinkt der Durchlaßwiderstand weiter ab. Ein weiterer Vorteil der Verwendung solcher Emitterinseln (8) liegt darin, daß die Spannungsrate dV/dt effektiv begrenzt werden kann.

Die in den Figuren verwendeten Bezugszeichen und deren Bedeutung sind in der Bezugszeichenliste zusammengefaßt, wobei in den Figuren gleiche Teile mit gleichen Bezugszeichen versehen sind. Die Figuren 1 bis 3 entsprechen den Figuren der US 5,668,385.

Ein erfindungsgemäßes Leistungshalbleiterbauelement umfaßt eine Siliziumschicht (1), in welche mehrere Schichten unterschiedlicher Dotierung eindiffundiert oder implantiert sind. Diese Schichten werden durch zwei Hauptflächen (2; 3) begrenzt. Der ersten Hauptfläche (2) ist eine Kathode (4), der zweiten Hauptfläche (3) ist eine Anode (5) zugeordnet.

Die Anode (5) bzw. die Kathode (4) werden durch entsprechende Metallisierungen (10; 22) gebildet.

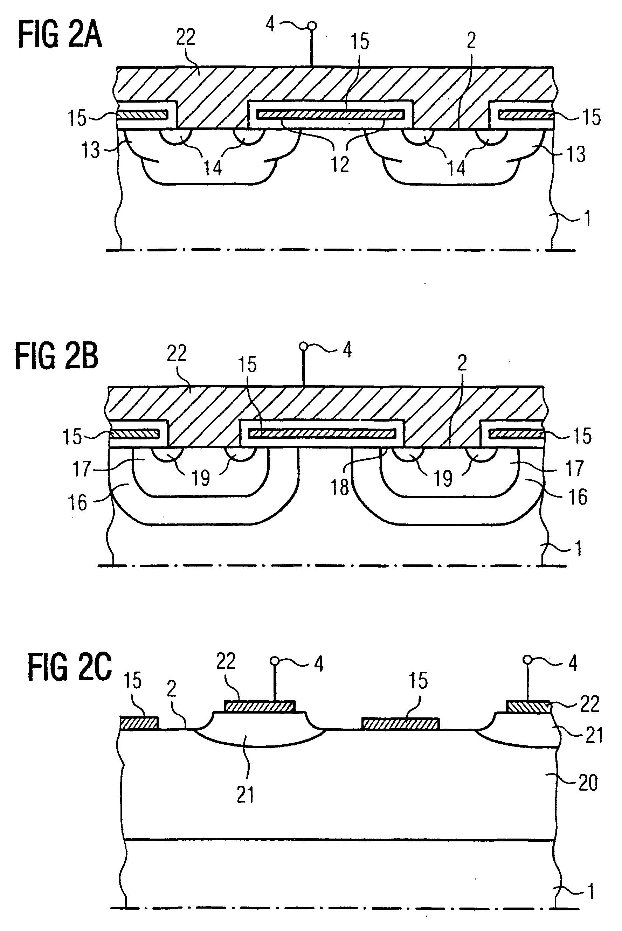

Die kathodenseitigen Strukturen für Halbleiterschalter wie IGBTs, MCTs und GTOs sind in den Figuren 2a bis c dargestellt, die anodenseitigen in den Figuren 1a bis b.

Die kathodenseitigen Strukturen können dabei mit den anodenseitigen der Figuren 1a, b kombiniert werden, indem sie entlang der strichpunktierten Linie aneinander gefügt werden.

Die Figur 1a zeigt eine erfindungsgemäße Stoppschicht (7). Die dort gezeigte anodenseitige Struktur besteht aus einer Anodenmetallisierung (10), einem transparenten Emitter (6) und einer Stoppschicht (7). Nach der Stoppschicht (7) folgt die Siliziumschicht (1), welche n-dotiert ist. Im Fall eines IGBT, MCT oder GTO stellt die Siliziumschicht (1) gleichzeitig die n-Basis dar. Der transparente Emitter (6) ist vorzugsweise stark p-dotiert und weist z.B. eine Tiefe von weniger als 1,0 µm und eine Dotierstoffkonzentration von 10¹⁸ cm⁻³ auf.

Die darauf folgende erfindungsgemäße Stoppschicht (7) ist n-dotiert, vorzugsweise wesentlich höher als die Siliziumschicht (1). Die Stoppschicht (7) ist mit zumindest einem Dotierstoff dotiert, der zumindest ein Donatorniveau aufweist, das zwischen Valenzbandkante und der Leitungsbandkante von Silizium liegt und einen Abstand von der Leitungsbandkante des Siliziums von mehr als 200 meV aufweist. Die hier gezeigten Dotierstoffe sind entweder Selen oder Schwefel oder Mischungen aus Selen und Schwefel.

Selen und Schwefel weisen im Vergleich zu den aus dem Stand der Technik bekannten Donatoren Phosphor, Arsen und Antimon die Eigenschaft auf, daß die Donatoratome bei Temperaturen zwischen -55°C und +175°C nur zu einem sehr kleinen Teil im thermischen Gleichgewicht in ionisierten Zustand vorliegen. Dadurch wird bei Schwefel und Selen bei gleichen, auf Gitterplätzen des Siliziums eingebauten und damit elektrisch aktiven Donatorkonzentrationen im Durchlaßbetrieb die Emittereigenschaften der Anode (6) wesentlich schwächer verändert, als dies bei den konventionellen Donatoren Phosphor, Arsen und Antimon der Fall wäre.

Die Stoppschicht (7) weist bei einem IGBT, MCT oder einem GTO eine Dotierstoffkonzentration N_{D} zwischen 5 x 10¹⁴ cm⁻³ und 5 x 10¹⁵ cm⁻³ auf. Bei IGBTs ist die Tiefe der Stoppschicht vorzugsweise (7) zwischen 10 µm und 25 µm.

Wird die erfindungsgemäße Stoppschicht (7) von einer Raumladungszone erfaßt, werden die dort eingebrachten Donatoratome vollständig als Donatoren aktiv, im Fall des eingebrachten Schwefels als Doppeldonatoren aktiv, d.h. Donatoren mit zwei freigesetzten Ladungsträgern, so daß ein Schwefelatom zweifach geladen ist.

Die Energieniveaus von Schwefel liegen so tief in der Siliziumbandlücke, daß sie erst bei Anlegen einer Raumladungszone vollständig elektrisch aktiviert werden. Ein Donatorniveau von Schwefel liegt 260 meV unterhalb der Leitungsbandkante des Siliziums und ein zweites Donatorniveau liegt bei 480 meV oberhalb der Valenzbandkante des Siliziums. Die Bandlücke von Silizium beträgt 1120 meV.

Dadurch wird einerseits bewirkt, daß die Stoppschicht (7) im Durchlaßzustand nur teilweise elektrisch aktiv ist, so daß der Teiltransistorverstärkungsfaktor αₚₙₚ des durch Anodenemitter (6), Stoppschicht (7) und Siliziumschicht (1) sowie die p-dotierten Kathodenstrukturen gebildeten parasitären Bipolartransistors nur relativ gering abgesenkt wird und die Durchlaßspannung dadurch wiederum gering gehalten werden kann.

Andererseits wird der von der Raumladungszone erfaßte Teil der Stoppschicht (7) im Sperrzustand vollständig aktiviert. Das elektrische Feld greift dabei in die erfindungsgemäße Stoppschicht (7) und ionisiert dort alle Donatoren, wobei die dort losgelösten Elektronen über das elektrische Feld sofort abtransportiert werden und somit nicht wieder mit einem ionisierten Donatoratom in Wechselwirkung treten können.

Die an sich gegenläufigen Anforderungen bezüglich der Durchlaßspannung und Sperrspannung an eine Stoppschicht (7) können durch die Verwendung der erfindungsgemäßen Donatoren somit wesentlich verbessert werden.

In einer alternativen Ausführungsform wird anstatt Schwefel Selen verwendet, das in Silizium innerhalb der Bandlücke zwei Donatorniveaus hat, die in etwa 310 meV bzw. 590 meV unterhalb der Leitungsbandkante des Siliziums liegen.

Die oben beschriebene Wirkung tritt bei der einfachsten Form der Anodenstruktur auf, welche in Figur 1a dargestellt ist. Entlang der strichpunktierten Linie können die Kathodenstrukturen von IGBTs (Figur 2a), MCTs (Figur 2b) oder GTOs (Figur 2c) oder auch von Bipolartransistoren oder Thyristoren (nicht gezeigt) angesetzt werden.

Figur 2a zeigt eine Kathodenstruktur eines IGBTs. Diese umfaßt eine n-dotierte Siliziumschicht (1), in dessen kathodenseitige Hauptfläche (2) eine Vielzahl von IGBT-Zellen bestehend aus p-dotierten Basiszonen (13) und darin eingebetteten n-dotierten Sourcezonen (14) eingebracht sind. Die Einbringung kann über Implantation und/oder Diffusion erfolgen. Die Kathode (4) ist dabei mit den Basiszonen (13) und den Sourcezonen (14) elektrisch leitend verbunden. Über der kathodenseitigen Hauptfläche (2) und zwischen jeweils zwei IGBT-Zellen ist eine über einen Isolator (12), der in der Regel ein Gateoxid ist, eine isolierte Gateelektrode (15) angeordnet.

Durch Anlegen einer Spannung an die Gateelektrode (15) kann der Stromfluß zwischen der Kathode (4) und der Anode (5) in bekannter Weise ein- und ausgeschaltet bzw. geregelt werden.

Die Figur 2b zeigt eine Kathodenstruktur eines MCTs. Wiederum wird von einer n-dotierten Siliziumschicht (1) ausgegangen. In die kathodenseitige Hauptfläche (2) der Siliziumschicht (1) ist eine p-dotierte Basis (20) und darin eine Mehrzahl von n-dotierten Kathodenzonen (21) eingebracht. Die Kathodenzonen (21) sind dabei mit der Kathode (4) elektrisch leitend verbunden. Wird das Gate (15) mit einem Steuerstrom beaufschlagt, kann der Strom zwischen Anode (5) und Kathode (4) in bekannter Weise ein- bzw. ausgeschaltet werden.

Die Kathodenstrukturen nach den Figuren 2a bis c können nun mit der Anodenstruktur nach Figur 1a, wie eingangs ausgeführt, kombiniert werden, so daß erfindungsgemäße IGBTs, MCTs oder GTOs bereitgestellt werden können.

Im folgenden wird auf die spezielle Situation bei Leistungsdioden eingegangen.

Leistungsdioden müssen bezüglich ihrer Verluste genauso wie steuerbare Leistungshalbleiterbauelemente, d.h. also IGBTs, MCTs, GTOs, Thyristoren und Bipolartransistoren wie sie vorgehend diskutiert wurden und bezüglich ihrer Schaltverluste optimiert werden.

Deshalb sind auch hier Leistungshalbleiterbauelemente mit minimaler Dicke anzustreben. Leistungsdioden weisen in der Regel einen abrupten Stromabriß am Ende der Reverse-Recovery-Phase auf. Dies kann selbst bei kleinsten Induktivitäten zu nicht hinnehmbaren Spannungsspitzen führen. Um dieses Risiko zu umgehen, werden derzeit demnach immer noch nicht bezüglich der Dicke optimierte Leistungsdioden verwendet, d.h. also Leistungsdioden, die bezüglich ihrer Dicke weitaus überdimensioniert sind. Diese Überdimensionierung führt aber in den elektrischen Schaltungen zu zusätzlichen Schaltverlusten.

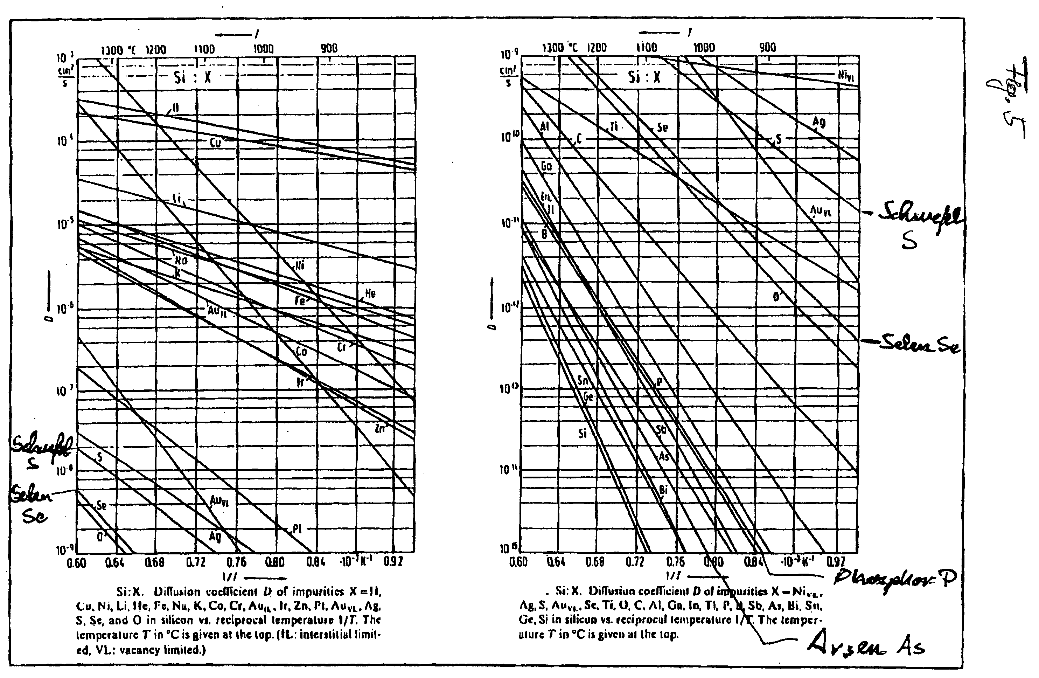

Aufgrund der Umkehrung des Stromes sind die Stoppschichten bei Leistungsdioden, und damit auch die erfindungsgemäße Stoppschicht (7), auf der Kathodenseite der Leistungsdiode angeordnet. Die Figur 3 zeigt eine solche Diode. Nach der Anode (5), welche durch eine Anodenmetallisierung (10) gebildet wird, folgt der transparente p-dotierte Emitter (6), die n-dotierte Siliziumschicht (1), und darauf die n-dotierte Stoppschicht (7). Die hier gezeigte Diode ist mit eine n-dotierten Kathodengebiet (21) versehen. Es wird darauf hingewiesen, daß selbstverständlich anstatt einem durchgehenden Kathodengebiet (21) auch eine Vielzahl von einzelnen n-dotierten Kathodengebieten vorgesehen sein kann.

Die Wirkung des transparenten Emitters (6) und der Stoppschicht (7) entspricht im wesentlichen derjenigen oben beschriebenen steuerbaren Leistungshalbleiterbauelemente. Die hier gezeigte Stoppschicht (7) ist wiederum mit Selen oder mit Schwefel dotiert.

Die Dotierstoffkonzentration N_{D} in der gezeigten Stoppschicht (7) ist dabei so bemessen, daß sie im Durchlaßfall noch von Ladungsträgern überschwemmt wird. Außerdem wird damit die Wirksamkeit der Stoppschicht (7) als Emitter möglichst wenig beeinflußt. Beim Abkommutieren aus dem Durchlaßbetrieb in den Sperrbetrieb wird beim Aufbau des elektrischen Feldes in der Stoppschicht (7) diese Überschwemmungsladung langsam abgebaut. Dies führt zum sanften Rückgang des Rückstromes bei gleichzeitig gleichmäßigem Ansteigen der Sperrspannung an der Leistungsdiode und damit zum gewünschten Schaltverhalten, dem sogenannten "Soft-Recovery"-Verhalten. Selbstverständlich kann aber auch für spezielle Verwendungen die Dotierstoffkonzentration N_{D} so eingestellt werden, daß ein "Hard-Recovery"-Verhalten erzielt wird.

Für eine Leistungsdiode, die beispielsweise auf eine Sperrspannung von 1200 V ausgelegt ist, haben sich für die Dimensionierung des p-dotierten Anodenemitters (6) eine Dotierstoffkonzentration zwischen 10¹⁶ und 10¹⁹ cm⁻³ bei einer Dikke von 3 µm bis 20 µm, für die Siliziumschicht (1) eine Dotierstoffkonzentration zwischen 10¹² und 10¹⁴ cm⁻³ bei einer Dicke zwischen 80 µm und 150 µm, für die Stoppschicht (7) eine Dotierstoffkonzentration zwischen 10¹⁴ und 10¹⁶ cm⁻³ und einer Dicke zwischen 10 µm und 50 µm als besonders vorteilhaft erwiesen.

Bei der Dimensionierung der Dicke und der Dotierstoffkonzentration der Siliziumschicht (1) und der Stoppschicht (7) wird berücksichtigt, daß im Sperrfall bei Anliegen der Volumendurchbruchspannung im Silizium 1,3 bis 1,8 x 10¹² Atome/cm² in der Raumladungszone ionisiert sind. Diese Flächenladung wird als Durchbruchsladung bezeichnet und läßt sich insbesondere beim Einbringen der Dotierstoffe durch Ionenimplantation bzw. über die Abscheidung epitaktischer Dotierschichten leicht kontrollieren.

Die Herstellung der oben beschriebenen Schichtenfolge ohne Benutzung der vorliegenden Erfindung gestaltet sich sehr schwierig. Bis etwa 1500 V Sperrspannung lassen sich die Siliziumschicht und die Stoppschicht sinnvoll über Epitaxieverfahren abscheiden wie nachfolgend erläutert. Während die Kathodenzone das Substratmaterial darstellt und der transparente Emitter üblicherweise durch Ausdiffusion von implantierten Dotierstoffen bzw. durch Diffusion aus der Gasphase erzeugt wird.

Bei höheren Sperrspannungen erweist sich die Epitaxie wegen der hohen Schichtdicken und der daraus resultierenden starken Dickenschwankungen, wie eingangs schon andiskutiert, als technisch und ökonomisch unsinnig. Deshalb werden bei diesen hohen Sperrspannungen Substratscheiben verwendet, in die die Stoppschichten bei hoher Temperatur und langen Diffusionen eingetrieben werden, bevor der transparente Emitter hergestellt wird. So werden bei Verwendung von konventionellen Dotierstoffen wie Phosphor, Arsen oder Antimon für die gewünschten Eindringtiefen Diffusionstemperaturen oberhalb von 1200°C benötigt. Die Diffusion dauert dann mehr als 20 Stunden.

Die Abscheidung von epitaktischen Schichen als Stoppschicht auf einem die Kathodenschicht bildenden Substrat führt zu Schwierigkeiten, da der Epitaxieschritt im aktiven Bereich des Bauelements liegt und meist eine erhöhte Kristallfehlerrate aufweist. Eine eindiffundierte Stoppschicht besitzt demnach Vorteile, weil sie einen nahezu perfekten Übergang zwischen der Stoppschicht und der Siliziumschicht (1) liefert.

Beim Einsatz von diffundierten Stoppschichten zu Beginn der Prozessierung können sich Schwierigkeiten ergeben, wenn während der Prozessierung der Anodenseite der Diode bzw. des Zellenfeldes bei IGBT's, z.B. im Bereich der Randstruktur, auf Getterschichten auf der Scheibenrückseite, nicht verzichtet werden kann. Letztere können die Emittereigenschaften negativ beeinflussen. Daneben verschlechtert die sehr lange Diffusionszeit bei der sehr hohen Temperatur eine ökonomisch vertretbare Fertigung von Leistungshalbleiterdioden ab etwa 1500 V Sperrspannung.

Darüber hinaus werden zunehmend aber auch Leistungshalbleiterbauelemente mit geringeren Sperrspannungen auf Substratmaterial ohne Epitaxieschichten hergestellt, weil die Emittereigenschaften der Kathodenseite nicht durch hochdotierte Trägermaterialien erzielt werden können, sondern für optimierte Bauelemente gezielt eingestellt werden müssen. Zu diesen Bauelementen zählen die gezeigten Leistungsdioden mit kontrollierten, schwachen Rückseitenemittern.

Die hier gemachten Aussagen sind selbstverständlich auch auf die Situation bei den eingangs diskutierten steuerbaren Leistungshalbleiterbauelementen, insbesondere bei den Non-Punch-Through-IGBTs anzuwenden.

Um für diese Leistungshalbleiterbauelemente mit Sperrspannungen oberhalb ca. 400 V trotzdem geringe Schaltverluste und geringe Durchlaßverluste kommen die hervorragenden Diffusionseigenschaften der diskutierten Dotierstoffe Schwefel und Selen bei vergleichsweise niedrigen Temperaturen zum Tragen. Durch diesen glücklichen Umstand können Leistungshalbleiterbauelemente während der Herstellung zuerst mit konventionell dicken Siliziumwafern gefertigt werden, die erste gegen Ende des Herstellprozesses, beispielsweise durch Dünnschleifen und Ätzen auf die Enddicke gebracht werden.

Zur Verbesserung der Durchlaßverluste und zur teilweisen Optimierung der Schaltverluste werden heute beim Einsatz von Stoppschicht-Techniken die benötigten Dosen von etwa 10¹² bis 10¹⁴ DA/cm² bevorzugt durch Ionenimplantation eingebracht. Das Ausheilen und Aktivieren der implantierten Dosis sowie der Eintreibeschritt erfolgen bei Temperaturen bis zu etwa 950°C.

Als typische Implantationsdosis kommt bei der Verwendung von Schwefel eine Dosis zwischen 10¹² und 10¹⁴ Schwefelatome/cm² in Frage. Die Verwendung einer solchen Schwefeldosis bringt gegenüber einer vergleichbaren Phosphordosis eine Absenkung von 10% des Spannungsabfalls im Durchlaßbetrieb.

Zusammenfassend läßt sich sagen, daß mit der Erfindung Leistungshalbleiterbauelemente, insbesondere für hohe Sperrspannungen, zur Verfügung gestellt werden, die überraschend gute physikalische Eigenschaften aufweisen, die sich positiv auf die Schaltverluste und Durchlaßverluste auswirken. Die Leistungshalbleiterbauelemente nach der vorliegenden Erfindung können in einer hervorragenden ökonomischen Art und Weise problemlos dünn ausgeführt werden, so daß sich neben neuen interessanten halbleiterphysikalischen Effekten auch interessante neue Fertigungswege eröffnen.

### Bezugszeichenliste

- 1: Siliziumschicht
- 2: erste Hauptfläche
- 3: zweite Hauptfläche
- 4: Kathode
- 5: Anode
- 6: transparenter Emitter
- 7: Stoppschicht
- 8: p⁺-Emitterinseln
- 9: Randabschluß
- 10: Anodenmetallisierung
- 12: Isolator
- 13: Basiszone
- 14: Sourcezone
- 15: Gateelektrode
- 16: p-Basis
- 17: n-Emitter
- 18: Kanalgebiet
- 19: p-Short-Gebiet
- 20: p-Basis
- 21: n-Kathode
- 22: Kathodenmetallisierung

## Patentansprüche

1. Leistungshalbleiterbauelement, insbesondere für hohe Sperrspannungen, umfassend
a) eine n-dotierte Siliziumschicht (1), in die zwischen einer ersten Hauptfläche (2) und einer zweiten Hauptfläche (3) mehrere n- oder p-dotierte Schichten eingebracht sind;
b) eine Kathode (4), welche der ersten Hauptfläche (2) zugeordnet ist und durch eine erste Metallisierung (22) gebildet wird, sowie eine Anode (5), welche durch eine die zweite Hauptfläche (3) bedeckende, zweite Metallisierung (10) gebildet wird; wobei
c) die Schichten, von der zweiten Hauptfläche (3) her gesehen, eine p-dotierte Anoden-Zone (6), an diese angrenzend eine n-dotierte Stoppschicht (7), die eine höhere Dotierstoffkonzentration aufweist als die Silizumschicht (1) und diese vollständig bedeckt, und daran angrenzend die Siliziumschicht (1) umfassen,
**dadurch gekennzeichnet, daß**
d) die Stoppschicht (7) mit zumindest einem Dotierstoff dotiert ist, der zumindest ein Donatorniveau aufweist, das zwischen der Valenzbandkante und der Leitungsbandkante von Silizium liegt und einen Abstand von der Leitungsbandkante des Silizium von mehr als 200 meV aufweist.

2. Leistungshalbleiterbauelement, insbesondere für hohe Sperrspannungen, umfassend
a) eine n-dotierte Siliziumschicht (1), in welche zwischen einer ersten Hauptfläche (2) und einer zweiten Hauptfläche (3) mehrere n- oder p-dotierte Schichten eingebracht sind;
b) eine Kathode (4), welche der ersten Hauptfläche (2) zugeordnet ist und durch eine erste Metallisierung (22) gebildet wird, sowie eine Anode (5), welche durch eine die zweite Hauptfläche (3) bedeckende, zweite Metallisierung (10) gebildet wird; wobei
c) die Schichten, von der zweiten Hauptfläche (3) her gesehen, eine Anoden-Zone (6), daran angrenzend die Silizium-, schicht (1) und an diese angrenzend die Stoppschicht (7), die eine höhere Dotierstoffkonzentration als die Siliziumschicht (1) aufweist und diese vollständig bedeckt, und daran angrenzend eine n-dotierte Kathodenzone (21) umfassen,
**dadurch gekennzeichnet, daß**
d) die Stoppschicht (7) mit zumindest einem Dotierstoff dotiert ist, der zumindest ein Donatorniveau aufweist, das zwischen der Valenzbandkante und der Leitungsbandkante von Silizium liegt und einen Abstand von der Leitungsbandkante des Silizium von mehr als 200 meV aufweist.

3. Leistungshalbleiterbauelement nach einem der Ansprüche 1 oder 2,
**dadurch gekennzeichnet, daß**
als Dotierstoff Selen vorgesehen ist.

4. Leistungshalbleiterbauelement nach Anspruch 1 oder 2,
**dadurch gekennzeichnet, daß**
als Dotierstoff Schwefel vorgesehen ist.

5. Leistungshalbleiterbauelement nach einem der Ansprüche 1 bis 4,
**dadurch gekennzeichnet, daß**
die Stoppschicht (7) eine Dotierstoffkonzentration 5 x 10¹⁴cm⁻³ ≤ N_{D} ≤ 5 x 10¹⁵cm⁻³ aufweist.

6. Leistungshalbleiterbauelement nach einem der Ansprüche 1 bis 5,
**dadurch gekennzeichnet, daß**
die Stoppschicht (7) eine Tiefe 1 µm ≤ d ≤ 50 µm aufweist.

7. Leistungshalbleiterbauelement nach einem der Ansprüche 1, 3, 4, 5 oder 6,
**dadurch gekennzeichnet, daß**
die Stoppschicht (7) eine Tiefe 10 µm ≤ d ≤ 25 µm aufweist.

8. Leistungshalbleiterbauelement nach einem der Ansprüche 2 bis 6,
**dadurch gekennzeichnet,**
**daß** die Stoppschicht (7) eine Tiefe 15 µm ≤ d ≤ 35 µm aufweist.

9. Leistungshalbleiterbauelement nach einem der Ansprüche 1 bis 8,
**dadurch gekennzeichnet, daß**
die Anoden-Zone (6) als ein transparenter Emitter ausgeführt ist, dessen Tiefe d₂ und Dotierstoffkonzentration so gewählt sind, daß mindestens 50% eines durch den Emitter (6) fließenden Gesamtstromes von Elektronen getragen wird.

10. Leistungshalbleiterbauelement nach Anspruch 9,
**dadurch gekennzeichnet, daß**
der transparente Anoden-Emitter (6) eine Tiefe 0,5 µm ≤ d₂ ≤ 5 µm aufweist.

11. Leistungshalbleiterbauelement nach Anspruch 1,
**dadurch gekennzeichnet, daß**
a'₁) von der kathodenseitigen Hauptfläche (2) eine Vielzahl von IGBT-Zellen bestehend aus p-dotierten Basiszonen (13) und darin eingebetteten n-dotierten Sourcezonen (14) eingebracht sind und die Kathode (4) mit der Basiszone (13) und in Sourcezonen (14) elektrisch leitend verbunden ist; und
a'₂) über der kathodenseitigen Hauptfläche (2) und zwischen jeweils zwei IGBT-Zellen eine über einen Isolator (12) isolierte Gateelektrode (15) vorgesehen ist.

12. Leistungshalbleiterbauelement nach Anspruch 1,
**dadurch gekennzeichnet, daß**
a'₁) von der kathodenseitigen Hauptfläche (2) eine p-dotierte Basis (20) und darin eine Mehrzahl von n-dotierten Kathodenzonen (21) eingebracht sind,
a'₂) und die Kathodenzonen (21) mit der Kathode (4) elektrisch leitend verbunden sind.

13. Leistungshalbleiterbauelement nach Anspruch 1,
**dadurch gekennzeichnet, daß**
a) von der kathodenseitigen Hauptfläche (2) eine Mehrzahl von MCT-Strukturen mit einer p-Basis (16), einem n-Emitter (17), einem Kanalgebiet (18) und einem p-Short-Gebiet (19) eingebracht sind; und
b) über der kathodenseitigen Hauptfläche (2) und zwischen zwei MCT-Strukturen eine Gateelektrode (15) isoliert angeordnet ist.

14. Leistungshalbleiterbauelement nach Anspruch 2,
**dadurch gekennzeichnet, daß**
als Anoden-Zone ein p-dotierter Anoden-Emitter vorgesehen ist.

15. Leistungshalbleiterbauelement nach Anspruch 2,
**dadurch gekennzeichnet, daß**
als Anoden-Emitter eine Schottky-Metallisierung vorgesehen ist.

16. Leistungshalbleiterbauelement nach Anspruch 2 oder 15,
**dadurch gekennzeichnet, daß**
das Leistungshalbleiterbauelement eine parasitäre Diode eines MISFETs ist, wobei die parasitäre Diode antiparallel von der Source zu der Drain des MISFETs geschaltet ist.

## Claims

1. Power semiconductor component, in particular for high reverse voltages, comprising
a) an n-doped silicon layer (1), into which a plurality of n- or p-doped layers are introduced between a first main area (2) and a second main area (3);
b) a cathode (4), which is assigned to the first main area (2) and is formed by a first metallization layer (22), and also an anode (5), which is formed by a second metallization layer (10) covering the second main area (3);
c) the layers, as seen from the second main area (3), comprising a p-doped anode zone (6), adjoining the latter an n-doped stop layer (7), which has a higher dopant concentration than the silicon layer (1) and completely covers the latter, and adjoining said stop layer the silicon layer (1),
**characterized in that**
d) the stop layer (7) is doped with at least one dopant which has at least one donor level which lies between the valence band edge and the conduction band edge of silicon and is more than 200 meV away from the conduction band edge of the silicon.

2. Power semiconductor component, in particular for high reverse voltages, comprising
a) an n-doped silicon layer (1), into which a plurality of n- or p-doped layers are introduced between a first main area (2) and a second main area (3);
b) a cathode (4), which is assigned to the first main area (2) and is formed by a first metallization layer (22), and also an anode (5), which is formed by a second metallization layer (10) covering the second main area (3);
c) the layers, as seen from the second main area (3), comprising an anode zone (6), adjoining the latter the silicon layer (1) and adjoining the latter the stop layer (7), which has a higher dopant concentration than the silicon layer (1) and completely covers the latter, and adjoining said stop layer an n-doped cathode zone (21),
**characterized in that**
d) the stop layer (7) is doped with at least one dopant which has at least one donor level which lies between the valence band edge and the conduction band edge of silicon and is more than 200 meV away from the conduction band edge of the silicon.

3. Power semiconductor component according to either of Claims 1 and 2,
**characterized in that**
selenium is provided as the dopant.

4. Power semiconductor component according to Claim 1 or 2,
**characterized in that**
sulphur is provided as the dopant.

5. Power semiconductor component according to one of Claims 1 to 4,
**characterized in that**
the stop layer (7) has a dopant concentration of 5 × 10¹⁴ cm⁻³ ≤ N_{D} ≤ 5 × 10¹⁵ cm⁻³.

6. Power semiconductor component according to one of Claims 1 to 5,
**characterized in that**
the stop layer (7) has a depth of 1 µm ≤ d ≤ 50 µm.

7. Power semiconductor component according to one of Claims 1, 3, 4, 5 or 6,
**characterized in that**
the stop layer (7) has a depth of 10 µm ≤ d ≤ 25 µm.

8. Power semiconductor component according to one of Claims 2 to 6,
**characterized in that**
the stop layer (7) has a depth of 15 µm ≤ d ≤ 35 µm.

9. Power semiconductor component according to one of Claims 1 to 8,
**characterized in that**
the anode zone (6) is embodied as a transparent emitter whose depth d₂ and dopant concentration are chosen such that at least 50% of a total current flowing through the emitter (6) is carried by electrons.

10. Power semiconductor component according to Claim 9,
**characterized in that**
the transparent anode emitter (6) has a depth of 0.5 µm ≤ d₂ ≤ 5 µm.

11. Power semiconductor component according to Claim 1,
**characterized in that**
a'₁) from the cathodal main area (2), a multiplicity of IGBT cells comprising p-doped base zones (13) and n-doped source zones (14) embedded therein are introduced and the cathode (4) is electrically conductively connected to the base zone (13) and the source zones (14); and
a'₂) a gate electrode (15) which is insulated by means of an insulator (12) is provided above the cathodal main area (2) and between two respective IGBT cells.

12. Power semiconductor component according to Claim 1,
**characterized in that**
a'₁) from the cathodal main area (2), a p-doped base (20) and, in the latter, a plurality of n-doped cathode zones (21) are introduced,
a'₂) and the cathode zones (21) are electrically conductively connected to the cathode (4).

13. Power semiconductor component according to Claim 1,
**characterized in that**
a) from the cathodal main area (2), a plurality of MCT structures having a p-type base (16), an n-type emitter (17), a channel region (18) and a p-type short region (19) are introduced; and
b) a gate electrode (15) is arranged in an insulated manner above the cathodal main area (2) and between two MCT structures.

14. Power semiconductor component according to Claim 2,
**characterized in that**
a p-doped anode emitter is provided as the anode zone.

15. Power semiconductor component according to Claim 2,
**characterized in that**
a Schottky metallization layer is provided as the anode emitter.

16. Power semiconductor component according to Claim 2 or 15,
**characterized in that**
the power semiconductor component is a parasitic diode of a MISFET, the parasitic diode being reverse-connected in parallel from the source to the drain of the MISFET.

## Revendications

1. Composant à semi-conducteur de puissance, notamment pour de hautes tensions de blocage comprenant
a) une couche (1) de silicium à dopage n dans laquelle sont introduites plusieurs couches à dopage n ou à dopage p entre une première surface (2) principale et une deuxième surface (3) principale ;
b) une cathode (4) qui est associée à la première surface (2) principale et qui est formée par une première métallisation (22) ainsi qu'une anode (5) qui est formée par une deuxième métallisation (10) recouvrant la deuxième surface (3) principale ; dans lequel
c) les couches considérées à partir de la deuxième surface (3) principale comprennent une zone (6) d'anode à dopage p, une couche (7) d'arrêt à dopage n adjacente à celle-ci, qui a une plus grande concentration de substance de dopage que la couche (1) de silicium et qui la recouvre complètement et, adjacente à celle-ci, la couche (1) de silicium,
**caractérisé en ce que**
d) la couche (7) d'arrêt est dopée par au moins une substance de dopage qui a au moins un niveau de donneurs qui se trouve entre le bord de la bande de valence et le bord de la bande de conduction du silicium et qui est à une distance du bord de la bande de conduction du silicium de plus de 200 meV.

2. Composant à semi-conducteur de puissance, notamment pour de hautes tensions de blocage comprenant
a) une couche (1) de silicium à dopage n dans laquelle sont introduites plusieurs couches à dopage n ou à dopage p entre une première surface (2) principale et une deuxième surface (3) principale ;
b) une cathode (4) qui est associée à la première surface (2) principale et qui est formée par une première métallisation (22) ainsi qu'une anode (5) qui est formée par une deuxième métallisation (10) recouvrant la deuxième surface (3) principale ; dans lequel
c) les couches comprenant, considérées à partir de la deuxième surface (3) principale, une zone (6) d'anode, la couche (1 ) de silicium qui en est adjacente et, de manière adjacente à celle-ci, la couche (7) d'arrêt qui a une concentration de substance de dopage plus grande que la couche (1) de silicium et qui la recouvre complètement et, adjacente à celle-ci, une zone (21) de cathode à dopage n,
**caractérisé en ce que**
d) la couche (7) d'arrêt est dopée par au moins une substance de dopage, qui a au moins un niveau de donneurs qui se trouve entre le bord de la bande de valence et le bord de la bande de conduction du silicium et qui est à une distance du bord de la bande de conduction du silicium de plus de 200 meV.

3. Composant à semi-conducteur de puissance suivant l'une des revendications 1 ou 2, **caractérisé en ce qu'**il est prévu du sélénium comme substance de dopage.

4. Composant à semi-conducteur de puissance suivant l'une des revendications 1 ou 2, **caractérisé en ce qu'**il est prévu du soufre comme substance de dopage.

5. Composant à semi-conducteur de puissance suivant l'une des revendications 1 à 4, **caractérisé en ce que** la couche (7) d'arrêt a une concentration de substance de dopage de 5 x 10¹⁴ cm⁻³ ≤ N_{D} ≤ 5 x 10¹⁵ cm⁻³.

6. Composant à semi-conducteur suivant l'une des revendications 1 à 5, **caractérisé en ce que** la couche (7) d'arrêt a une profondeur de 1 µm ≤ d ≤ 50 µm.

7. Composant à semi-conducteur de puissance suivant l'une des revendications 3, 4, 5 ou 6, **caractérisé en ce que** la couche (7) d'arrêt a une profondeur de 10 µm ≤ d ≤ 25 µm.

8. Composant à semi-conducteur de puissance suivant l'une des revendications 2 à 6, **caractérisé en ce que** la couche (7) d'arrêt a une profondeur de 15 µm ≤ d ≤ 35 µm.

9. Composant à semi-conducteur de puissance suivant l'une des revendications 1 à 8, **caractérisé en ce que** la zone (6) d'anode est réalisée sous la forme d'un émetteur transparent dont la profondeur d₂ et la concentration de la substance de dopage sont choisies de façon à ce qu'au moins 50 % d'un courant global passant dans l'émetteur (6) sont portés par des électrons.

10. Composant à semi-conducteur de puissance suivant la revendication 9, **caractérisé en ce que** l'émetteur (6) d'anode transparent a une profondeur de 0,5 µm ≤ d₂ ≤ 5 µm.

11. Composant à semi-conducteur de puissance suivant la revendication 1, **caractérisé en ce que**
a'₁) il est mis, à partir de la surface (2) principale du côté de la cathode, une pluralité de cellules IGBT constituées de zones (13) de base à dopage p et de zones (14) de source à dopage n qui y sont incorporées et la cathode (4) est reliée de manière conductrice de l'électricité à la zone (13) de base et dans les zones (14) de source ;
a'₂) au-dessus de la surface (2) principale du côté de la cathode et entre, respectivement, deux cellules IGBT est prévue une électrode (15) de grille isolée par un isolateur (12).

12. Composant à semi-conducteur de puissance suivant la revendication 1, **caractérisé en ce que**
a'₁) à partir de la surface (2) principale du côté de la cathode est mise une base (20) à dopage p et en son sein une multiplicité de zones (21) de cathode à dopage n ;
a'₂) et les zones (21) de cathode sont reliées de manière conductrice de l'électricité à la cathode (4).

13. Composant à semi-conducteur de puissance suivant la revendication 1, **caractérisé en ce que**
a) à partir de la surface (2) principale du côté de la cathode, il est mis une multiplicité de structures MCT ayant une base (16) de type p, un émetteur (17) de type n, une zone (18) de canal et une zone (19) Short de type p ;
b) au-dessus de la surface (2) principale du côté de la cathode et entre deux structures MCT est disposée de manière isolée une électrode (15) de grille.

14. Composant à semi-conducteur de puissance suivant la revendication 2, **caractérisé en ce qu'**il est prévu comme zone d'anode un émetteur d'anode de type p.

15. Composant à semi-conducteur de puissance suivant la revendication 2, **caractérisé en ce qu'**il est prévu comme émetteur d'anode une métallisation de Schottky.

16. Composant à semi-conducteur de puissance suivant la revendication 2 ou 15, **caractérisé en ce que** le composant à semi-conducteur de puissance est une diode de parasite d'un MISFET, la diode parasite étant montée en antiparallèle de la source par rapport au drain du MISFET.
